# EUROPEAN PATENT APPLICATION

(11) **EP 3 154 085 A1**
(43) Date of publication of application: **12.04.2017**
(21) Application number: 16182289.5
(22) Date of filing: 02.08.2016
(51) Int. Cl.: H01L 25/10, H01L 21/60, H01L 25/065, H01L 21/56

(54) **SEMICONDUCTOR PACKAGE STRUCTURE AND METHOD FOR FORMING THE SAME**

(30) Priority: 05.10.2015 US 201562237267 P; 15.07.2016 US 201615212125
(71) Applicant: MediaTek Inc., Hsin-Chu 300 (TW)
(72) Inventor: LIU, Nai-Wei, 830 Kaohsiung City (TW); LIN, Tzu-Hung, 302 Hsinchu County (TW); PENG, I-Hsuan, 300 Hsinchu City (TW); HSIAO, Ching-Wen, 300 Hsinchu City (TW); HUANG, Wei-Che, 310 Hsinchu County (TW)
(74) Representative: Goddar, Heinz J.

(57) **Abstract**

A semiconductor package structure is provided. The semiconductor package structure includes a semiconductor body (100) and a conductive structure (140) disposed below the semiconductor body. The semiconductor package structure also includes an insulating layer (150) surrounding the conductive structure. The semiconductor package structure further includes a redistribution layer structure (240) coupled to the conductive structure. In addition, the semiconductor package structure includes a molding compound (230) surrounding the semiconductor body. A portion of the molding compound extends between the redistribution layer structure and the semiconductor body.

## Description

### CROSS REFERENCE TO RELATED APPLICATIONS

This Application claims the benefit of U.S. Provisional Application No. 62/237,267 filed on October 05, 2015, the entirety of which is incorporated by reference herein.

### BACKGROUND OF THE INVENTION

### Field of the Invention

The present invention relates to a semiconductor package structure, and in particular to a package-on-package (POP) semiconductor package structure and methods for forming the same.

### Description of the Related Art

A semiconductor package can not only provide a semiconductor die with protection from environmental contaminants, but it can also provide an electrical connection between the semiconductor die packaged therein and a printed circuit board. For example, a semiconductor die may be enclosed in an encapsulating material, and traces are electrically connected to the semiconductor die and the printed circuit board.

However, adhesion between a semiconductor die and an encapsulating material is poor. Delamination at bi-material interfaces, such as an interface between the semiconductor die and the encapsulating material, would be easily induced. Also, stress concentrated at bi-material interfaces would result in cracks in the traces.

Thus, a novel semiconductor package structure and methods for forming the same are desirable.

### BRIEF SUMMARY OF THE INVENTION

A semiconductor package structure and a method for forming a semiconductor package structure are provided.

An exemplary embodiment of a semiconductor package structure includes a semiconductor body and a conductive structure disposed below the semiconductor body. The semiconductor package structure also includes an insulating layer surrounding the conductive structure. The semiconductor package structure further includes a redistribution layer structure coupled to the conductive structure. In addition, the semiconductor package structure includes a molding compound surrounding the semiconductor body. A portion of the molding compound extends between the redistribution layer structure and the semiconductor body.

Another exemplary embodiment of a semiconductor package structure includes a semiconductor body and a conductive pad disposed below a surface of the semiconductor body. The semiconductor package structure also includes a redistribution layer structure disposed below the semiconductor body and a conductive structure between the conductive pad and the redistribution layer structure. The surface of the semiconductor body faces the redistribution layer structure. The semiconductor package structure further includes an insulating layer between the surface of the semiconductor body and the redistribution layer structure. A portion of the surface is exposed from the insulating layer. In addition, the semiconductor package structure includes a molding compound surrounding the semiconductor body and covering the portion of the surface.

An exemplary embodiment of a method for forming a semiconductor package structure includes providing a die. The die includes a semiconductor body and a conductive structure on a surface of the semiconductor body. The die also includes an insulating layer surrounding the conductive structure. A portion of the surface is exposed from the insulating layer. The method also includes forming a molding compound surrounding the semiconductor body and covering the portion of the surface. The method further includes forming a redistribution layer structure on the molding compound and the insulating layer.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIGS. 1A-1G are cross-sectional views of various stages of a method for forming a semiconductor package structure, in accordance with some embodiments of the disclosure.
FIGS. 2A-2B are cross-sectional views of various stages of a method for forming a semiconductor package structure, in accordance with some embodiments of the disclosure.
FIG. 3 is a cross-sectional view of a semiconductor package structure, in accordance with some embodiments of the disclosure.
FIG. 4 is a cross-sectional view of a semiconductor package structure, in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions may or may not correspond to actual dimensions in the practice of the invention.

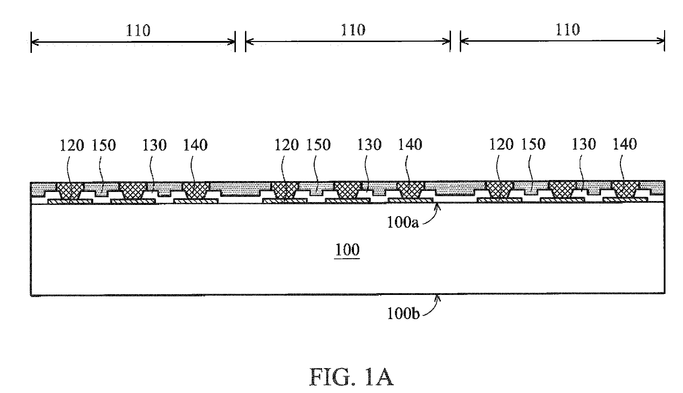

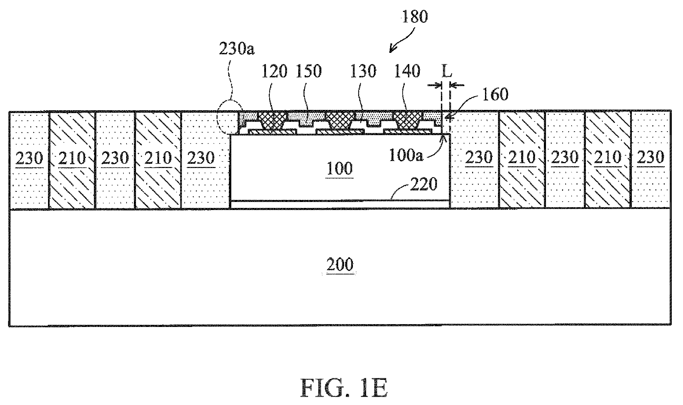

FIGS. 1A-1G are cross-sectional views of various stages of a method for forming a semiconductor package structure, in accordance with some embodiments of the disclosure. Additional operations can be provided before, during, and/or after the stages described in FIGS. 1A-1G. Some of the stages that are described can be replaced or eliminated for different embodiments. Additional features can be added to the semiconductor package structure. Some of the features described below can be replaced or eliminated for different embodiments. To simplify the diagram, only a portion of the semiconductor package structure is depicted in FIGS. 1A-1G.

As shown in FIG. 1A, a semiconductor body 100 is provided. In some embodiments, the semiconductor body 100 is a wafer or a panel. The semiconductor body 100 may include one or more chip regions 110. In some embodiments, the semiconductor body 100 includes a semiconductor material, such as silicon or another suitable semiconductor material.

An interconnection structure is formed on a surface 100a of the semiconductor body 100, which may be referred to as an active surface. In some embodiments, the interconnection structure includes multiple conductive pads 120 and a dielectric layer 130. As shown in FIG. 1A, the conductive pads 120 are located on the surface 100a in each chip region 110. The dielectric layer 130 is located on the surface 100a and partially covers the conductive pads 120.

The interconnection structure may further include one or more conductive traces, an interlayer dielectric (ILD) layer, and inter-metal dielectric (IMD) layers below the conductive pads 120 and the dielectric layer 130. For example, the conductive pads 120 may be the topmost layer of conductive traces in the interconnection structure. The dielectric layer 130 may be the topmost layer of dielectric layers in the interconnection structure and may be referred to as a passivation layer. To simplify the diagram, only the conductive pads 120 and the dielectric layer 130 are depicted herein as an example.

As shown in FIG. 1A, multiple conductive structures 140 are formed in openings of the dielectric layer 130 that partially expose the conductive pads 120. The conductive structures 140 protrude from the dielectric layer 130. In other words, only a lower portion of the conductive structures 140 is surrounded by the dielectric layer 130.

In some embodiments, the conductive structures 140 are bumps or pillars. In some embodiments, the conductive structures 140 include copper or another suitable conductive material.

As shown in FIG. 1A, an insulating layer 150 is formed on the dielectric layer 130. The insulating layer 150 surrounds an upper portion of the conductive structures 140. The insulating layer 150 is a buffer layer for protecting the conductive structures 140. The insulating layer 150 may also be referred to as a flattening layer for providing a flat surface on the semiconductor body 100.

In some embodiments, the insulating layer 150 includes polymer or another suitable insulating material. In some embodiments, the insulating layer 150 is formed by a deposition process (such as a coating process, a physical vapor deposition process, a chemical vapor deposition process or another suitable process).

In some embodiments, the deposited insulating layer 150 covers the conductive structures 140. Afterwards, a thinning process (such as an etching process, a milling process, a grinding process or a polishing process) is performed on the deposited insulating layer 150. As a result, the top surfaces of the conductive structures 140 are exposed from the thinned insulating layer 150. In some embodiments, the top surface of the insulating layer 150 is substantially coplanar with the top surfaces of the conductive structures 140.

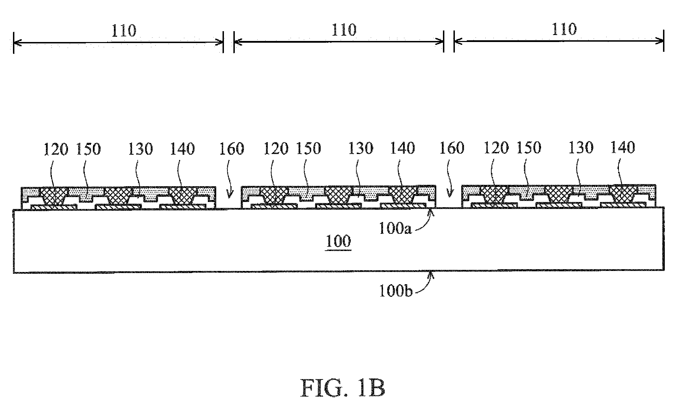

As shown in FIG. 1B, a thinning process is performed on a surface 100b of the semiconductor body 100 that is opposite to the surface 100a. As a result, the thickness of the semiconductor body 100 is reduced.

Afterwards, one or more first openings 160 are formed in the insulating layer 150 and the dielectric layer 130. As a result, the insulating layer 150 and the dielectric layer 130 expose a portion of the surface 100a of the semiconductor body 100 through the first openings 160. As mentioned above, there may be other dielectric layers between the dielectric layer 130 and the semiconductor body 100. The first openings 160 may further penetrate those dielectric layers to expose the surface 100a.

Each of the first openings 160 is located between two adjacent chip regions 110 and extends into the chip regions 110. In other words, the first openings 160 are positioned on the edge of the chip regions 110 and extend outside of the chip regions 110.

In some embodiments, the first openings 160 extend along the chip regions 110. In some embodiments, the first openings 160 continuously surround the center of the chip regions 110. For example, the first openings 160 may continuously surround the conductive pads 120 and the conductive structures 140 as viewed from a top view.

In some embodiments, a laser grooving process is performed on the insulating layer 150 and the dielectric layer 130 to form the first openings 160. In some embodiments, the insulating layer 150 and the dielectric layer 130 is cut by a suitable blade to form the first openings 160. In some embodiments, lithography and etching processes are performed on the insulating layer 150 and the dielectric layer 130 to form the first openings 160. The etching process may be a dry etching process, a wet etching process, a plasma etching process, a reactive ion etching process, or another suitable process.

In some other embodiments, the insulating layer 150 includes a photosensitive material, and a lithography process is performed on the insulating layer 150. Some portions of the insulating layer 150 are exposed and developed to be removed. As a result, the first openings 160 are formed in the insulating layer 150 without extending into the dielectric layer 130. As mentioned above, there may be other dielectric layers between the dielectric layer 130 and the semiconductor body 100. The first openings 160 may be formed in the insulating layer 150 without extending into those dielectric layers.

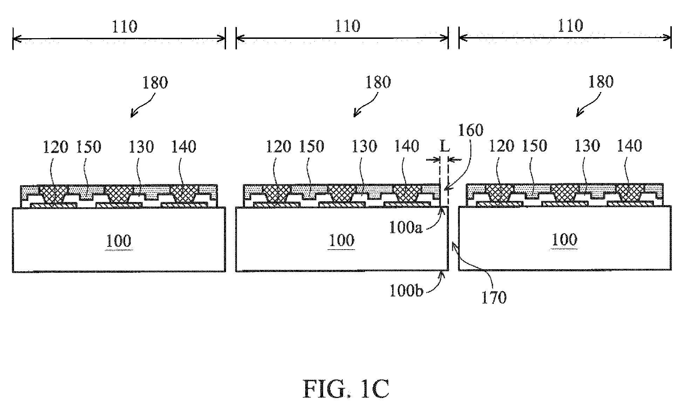

As shown in FIG. 1C, one or more second openings 170 are formed in the semiconductor body 100. The second openings 170 extend along the first openings 160 and along the chip regions 110. Each of the second openings 170 is in communication with one of the first openings 160. As a result, portions of the semiconductor body 100 corresponding to the chip regions 110 are separated from each other. Accordingly, multiple chips or dies 180 are formed. In some embodiments, the semiconductor body 100 is cut by a suitable blade to form the dies 180.

In some embodiments, the first openings 160 are wider than the second openings 170. Accordingly, the surface 100a of the semiconductor body 100 in each die 180 is partially exposed through the first openings 160. In other words, the semiconductor body 100 is wider than the insulating layer 150 and the dielectric layer 130, as shown in FIG. 1C.

The exposed portion of the surface 100a in each die 180 has a length L. In some embodiments, the length L is in a range from about 1 µm to about 200 µm. In some embodiments, the length L is in a range from about 10 µm to about 200 µm. In some embodiments, the difference between the widths of the first openings 160 and the second openings 170 is substantially equal to two times of the length L, as shown in FIG. 1C. In some embodiments, the difference between the widths of the semiconductor body 100 and the insulating layer 150 (or the dielectric layer 130) is substantially equal to two times of the length L, as shown in FIG. 1C.

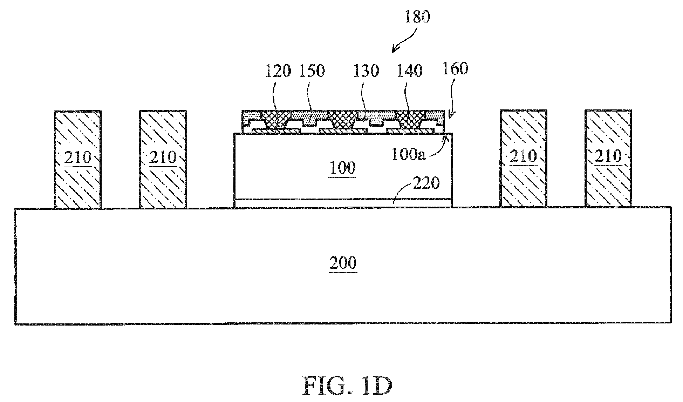

As shown in FIG. 1D, a carrier substrate 200 is provided. In some embodiments, the carrier substrate 200 is a wafer or a panel. The carrier substrate 200 may include glass or another suitable supporting material.

Subsequently, multiple conductive vias 210 are formed on the carrier substrate 200. The conductive vias 210 may be through interposer vias (TIVs). In some embodiments, the conductive vias 210 are pillars or other suitable conductive structures. In some embodiments, the conductive vias 210 include copper or another suitable conductive material. In some embodiments, the conductive vias 210 are formed by an electroplating process or another suitable process.

Embodiments of the disclosure are not limited thereto. In some other embodiments, an RDL structure may be formed on the carrier substrate 200 before the formation of the conductive vias 210. Afterwards, the conductive vias 210 are formed on the RDL structure on the carrier substrate 200.

As shown in FIG. 1D, the die 180 including the partially exposed surface 100a is bonded onto the carrier substrate 200. In some embodiments, the surface 100b of the semiconductor body 100 in the die 180 is attached to the carrier substrate 200 through an adhesive layer 220. In some embodiments, the adhesive layer 220 includes glue or another suitable adhesive material. In some other embodiments, multiple dies 180 including the partially exposed surface 100a are bonded onto the carrier substrate 200.

In some embodiments, the dies 180 are active devices. For example, the dies 180 may be a logic die including a central processing unit (CPU), a graphics processing unit (GPU), a dynamic random access memory (DRAM) controller or any combination thereof. In some other embodiments, one or more passive devices are also bonded onto the carrier substrate 200. The passive devices may or may not include a partially exposed surface that is similar to the partially exposed surface 100a.

In some embodiments, the die 180 is positioned between two of the conductive vias 210. In some embodiments, the die 180 is surrounded by the conductive vias 210 as viewed from a top view.

As shown in FIG. IE, a molding compound 230 is formed on the carrier substrate 200. The molding compound 230 surrounds and adjoins the sidewalls of the semiconductor body 100, the dielectric layer 130, the insulating layer 150, and the adhesive layer 220. The molding compound 230 also surrounds and adjoins the conductive vias 210.

In accordance with some embodiments of the disclosure, a portion 230a of the molding compound 230 laterally extends from a sidewall of the semiconductor body 100 to a sidewall of the insulating layer 150 and the dielectric layer 130. As a result, the partially exposed surface 100a is covered by the extending portion 230a of the molding compound 230.

In some embodiments, the extending portion 230a of the molding compound 230 has an extending length (i.e., the length L) in a range from about 1 µm to about 200 µm. In some embodiments, the extending length is in a range from about 10 µm to about 200 µm.

In some embodiments, a sidewall of the extending portion 230a of the molding compound 230 adjoins the sidewall of the insulating layer 150 and the dielectric layer 130, and is non-coplanar with the sidewall of the semiconductor body 100. The extending portion 230a of the molding compound 230 vertically overlaps the semiconductor body 100. In some embodiments, the extending portion 230a of the molding compound 230 continuously surrounds the insulating layer 150 and the dielectric layer 130 as viewed from a top view.

In some embodiments, the extending portion 230a of the molding compound 230 is in direct contact with the partially exposed surface 100a. In some other embodiments, the extending portion 230a of the molding compound 230 is not in direct contact with the partially exposed surface 100a.

In some embodiments, an edge portion of the semiconductor body 100 is sandwiched between the adhesive layer 220 and the extending portion 230a of the molding compound 230. In some embodiments, as shown in FIG. IE, an upper portion of the molding compound 230 between the conductive via 210 and the insulating layer 150 (or the dielectric layer 130) is wider than a lower portion of the molding compound 230 between the conductive via 210 and the semiconductor body 100.

As mentioned above, in some other embodiments, one or more passive devices including a partially exposed surface are also bonded onto the carrier substrate 200. The partially exposed surface of the passive device(s) may be also covered by an extending portion of the molding compound 230.

In some embodiments, the molding compound 230 includes a nonconductive material such as an epoxy, a resin, a moldable polymer, or another suitable molding material. In some embodiments, the molding compound 230 is applied as a substantial liquid, and then is cured through a chemical reaction. In some other embodiments, the molding compound 230 is an ultraviolet (UV) or thermally cured polymer applied as a gel or malleable solid, and then is cured through a UV or thermal curing process. The molding compound 230 may be cured with a mold.

In some embodiments, the material of the molding compound 230 is different from that of the insulating layer 150. In some embodiments, the material of the insulating layer 150 has good gap-filling ability. For example, it may be easier for the material of the insulating layer 150 to fill spaces between the conductive structures 140 than the material of the molding compound 230. Compared with the material of the molding compound 230, it may be much easier to perform defect tests and/or alignment steps when the surface 100a of the semiconductor body 100 is covered by the material of the insulating layer 150.

In some embodiments, the deposited molding compound 230 covers the top surfaces of the conductive vias 210, the insulating layer 150 and the conductive structures 140. Afterwards, a grinding process is performed to thin the deposited molding compound 230. The extending portion 230a of the molding compound 230 vertically overlapping the semiconductor body 100 is also thinned. As a result, the thinned molding compound 230 exposes the top surfaces of the conductive vias 210, the insulating layer 150 and the conductive structures 140.

In some embodiments, the top surface of the molding compound 230 is substantially coplanar with the top surfaces of the conductive vias 210. In some embodiments, the top surface of the molding compound 230 is also substantially coplanar with the top surfaces of the insulating layer 150 and the conductive structures 140.

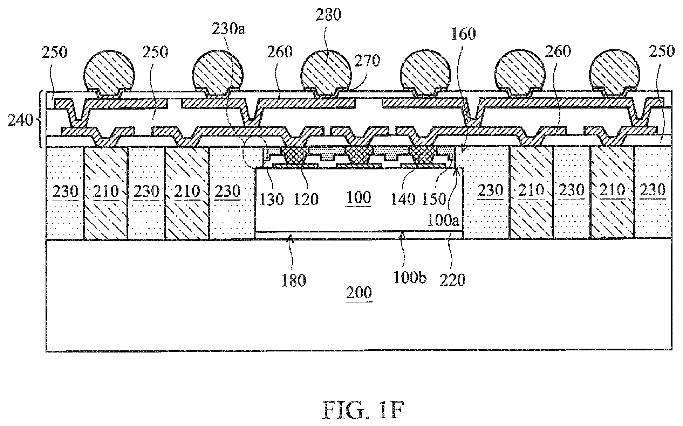

As shown in FIG. 1F, a redistribution layer (RDL) structure 240 is formed on the molding compound 230 and the insulating layer 150. In some embodiments, the RDL structure 240 includes one or more inter-metal dielectric (IMD) layers 250 and one or more conductive traces 260. The conductive traces 260 are disposed in the IMD layers 250 and are surrounded by them. Pad portions of the conductive traces 260 are exposed from the top surface of the RDL structure 240. It should be noted that the number and configuration of the IMD layers 250 and the conductive traces 260 shown in figures are only some examples and are not limitations to the present invention.

The conductive pads 120 are electrically connected to the conductive traces 260 of the RDL structure 240 through the conductive structures 140. The conductive vias 210 are directly electrically connected to the conductive traces 260 of the RDL structure 240.

In some embodiments, as shown in FIG. 1F, the extending portion 230a of the molding compound 230 is sandwiched between the RDL structure 240 and the semiconductor body 100. More specifically, the extending portion 230a of the molding compound 230 is sandwiched between the bottommost layer of the IMD layers 250 and the partially exposed surface 100a.

As shown in FIG. 1F, one or more conductive components 280 are formed on the RDL structure 240. For example, the conductive components 280 are formed on the pad portions of the conductive traces 260. In some embodiments, the conductive components 280 are bonding balls (such as solder balls), or another suitable conductive structures.

In some embodiments, there is an under-bump metallurgy (UBM) layer 270 between one of the conductive components 280 and one pad portion of the conductive traces 260. The UBM layer 270 may include one or more layers, such as a barrier layer and a seed layer. The UBM layer 270 including a single layer is depicted herein as an example.

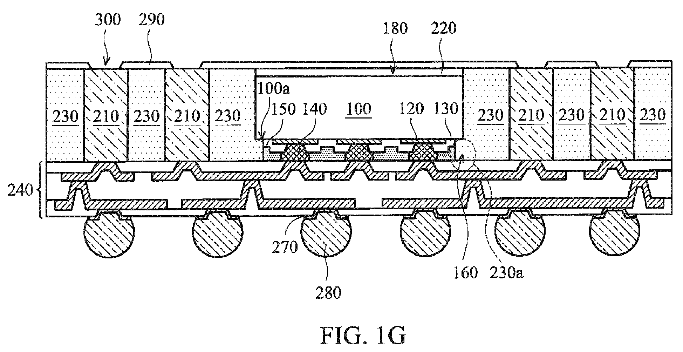

As shown in FIG. 1G, the carrier substrate 200 is removed. As a result, the adhesive layer 220 attached to the surface 100b of the semiconductor body 100 is exposed. In some embodiments, the adhesive property of the adhesive layer 220 is eliminated to debond the carrier substrate 200.

Afterwards, a backside film (BSF) 290 is formed on the adhesive layer 220 and the molding compound 230. The BSF 290 and the semiconductor body 100 are located on two opposite sides of the adhesive layer 220. In some embodiments, warpage of the formed semiconductor package can be prevented by the BSF 290. In some other embodiments, the BSF 290 may be omitted.

In some embodiments, as shown in FIG. 1G, one or more openings 300 are formed in the BSF 290. In some embodiments, the openings 300 are formed by a laser drilling process or another suitable process.

The openings 300 expose a surface of the conductive vias 210 that faces away the RDL structure 240 for further electrical connection. For example, a chip/die may be bonded on the BSF 290 and is electrically connected to the conductive vias 210 through the openings 300. Alternatively, a package may be stacked on the BSF 290 and is electrically connected to the conductive vias 210 through the openings 300. For example, the package may be a memory package (such as a DRAM package) or another suitable package.

In accordance with some embodiments of the disclosure, a singulation process may be performed after the formation of the BSF 290. For example, the RDL structure 240, the molding compound 230, and the BSF 290 may be cut. As a result, multiple semiconductor packages are formed.

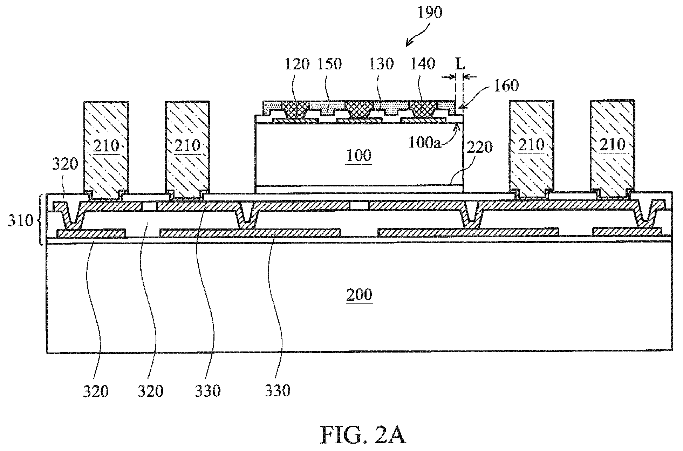

Many variations and/or modifications can be made to embodiments of the disclosure. FIGS. 2A-2B are cross-sectional views of various stages of a method for forming a semiconductor package structure, in accordance with some embodiments of the disclosure. Elements in FIGS. 2A-2B that are the same as those in FIGS. 1A-1G are labeled with the same reference numbers as in FIGS. 1A-1G and are not described again for brevity.

As shown in FIG. 2A, a chip or die 190 is provided. The structure of the die 190 is similar to that of the die 180 in FIGS. 1C-1G. The method for forming the die 190 is also similar to the method for forming the die 180, as shown in FIGS. 1A-1C. The difference between the dies 180 and 190 is that the first opening 160 of the die 180 penetrates the insulating layer 150 and the dielectric layer 130 while the first opening 160 of the die 190 only penetrates the insulating layer 150. As a result, as shown in FIG. 2A, the insulating layer 150 exposes an edge portion of the surface of the dielectric layer 130 through the first opening 160. Accordingly, the dielectric layer 130 and the semiconductor body 100 are wider than the insulating layer 150.

In some embodiments, the insulating layer 150 includes a photosensitive material, and a lithography process is performed on the insulating layer 150. Some portions of the insulating layer 150 are exposed and developed to be removed. As a result, the first opening 160 is formed in the insulating layer 150 without extending into the dielectric layer 130. As mentioned above, there may be other dielectric layers between the dielectric layer 130 and the semiconductor body 100. In some embodiments, the first opening 160 does not extend into those dielectric layers.

As shown in FIG. 2A, an RDL structure 310, which is similar to the RDL structure 240, is formed on the carrier substrate 200. In some embodiments, the RDL structure 310 includes one or more IMD layers 320 and one or more conductive traces 330. The conductive traces 330 are disposed in the IMD layers 320 and are surrounded by them. Pad portions of the conductive traces 330 are exposed from the top surface of the RDL structure 310.

Subsequently, multiple conductive vias 210 are formed on the RDL structure 310. Afterwards, the die 190 including the first opening 160 is bonded onto the RDL structure 310. In some embodiments, the surface 100b of the semiconductor body 100 in the die 190 is attached to the RDL structure 310 through the adhesive layer 220. In some other embodiments, multiple dies 190 including the first opening 160 are bonded onto the RDL structure 310.

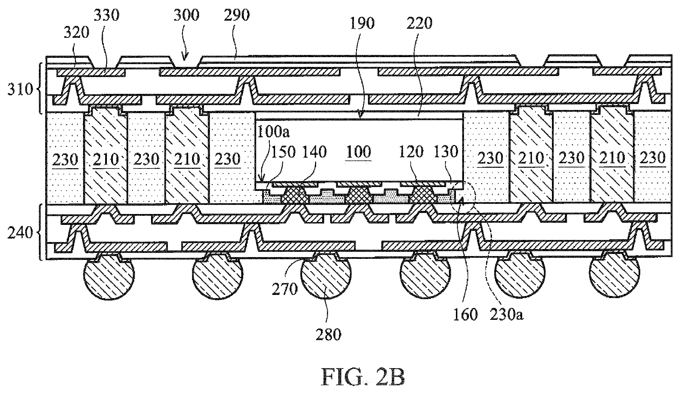

As shown in FIG. 2B, the molding compound 230 surrounds and adjoins the sidewalls of the semiconductor body 100, the dielectric layer 130, the insulating layer 150, and the adhesive layer 220. The molding compound 230 also surrounds and adjoins the conductive vias 210.

In accordance with some embodiments of the disclosure, the portion 230a of the molding compound 230 laterally extends from a sidewall of the semiconductor body 100 to a sidewall of the insulating layer 150. Since the first opening 160 of the die 190 penetrates the insulating layer 150 without extending into the dielectric layer 130, the extending portion 230a shown in FIG. 2B is thinner than the extending portion 230a shown in FIG. 1G.

In some embodiments, a sidewall of the extending portion 230a of the molding compound 230 adjoins the sidewall of the insulating layer 150, and is non-coplanar with the sidewall of the semiconductor body 100 and the dielectric layer 130. The extending portion 230a of the molding compound 230 vertically overlaps the semiconductor body 100 and the dielectric layer 130. In some embodiments, the extending portion 230a of the molding compound 230 continuously surrounds the insulating layer 150 as viewed from a top view. In some embodiments, the extending portion 230a of the molding compound 230 is in direct contact with the surface of the dielectric layer 130 that faces away the RDL structure 310.

In some embodiments, as shown in FIG. 2B, the extending portion 230a of the molding compound 230 is sandwiched between the dielectric layer 130 and the RDL structure 240. More specifically, the extending portion 230a of the molding compound 230 is sandwiched between an edge portion of the dielectric layer 130 and the IMD layers 250 of the RDL structure 240.

As shown in FIG. 2B, the carrier substrate 200 is removed. As a result, one of the IMD layers 320 of the RDL structure 310 is exposed. Afterwards, the BSF 290 is formed on the RDL structure 310. One or more openings 300 are formed in the BSF 290 and extend into one of the IMD layers 320 of the RDL structure 310. As a result, one of the conductive traces 330 of the RDL structure 310 is exposed through the openings 300 for further electrical connection.

In accordance with some embodiments of the disclosure, a singulation process may be performed after the formation of the BSF 290. For example, the RDL structure 240, the molding compound 230, the RDL structure 310, and the BSF 290 may be cut. As a result, multiple semiconductor packages are formed.

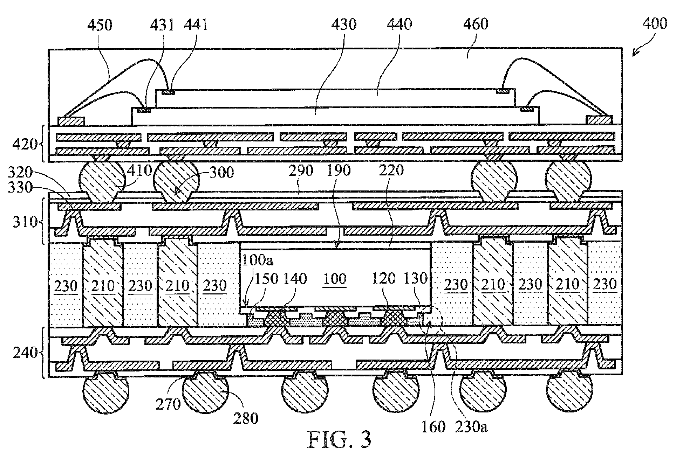

As mentioned above, a semiconductor package can be stacked on the BSF 290 and is electrically connected to the conductive vias 210 through the openings 300. For example, as shown in FIG. 3, a semiconductor package 400 is vertically stacked on the semiconductor package structure shown in FIG. 2B. As a result, a package-on-package (POP) structure is provided.

FIG. 3 is a cross-sectional view of a semiconductor package structure, in accordance with some embodiments of the disclosure. Elements in FIG. 3 that are the same as those in FIGS. 1A-1G and FIG. 2 are labeled with the same reference numbers as in FIGS. 1A-1G and FIG. 2 and are not described again for brevity. It should be noted that the structure of the semiconductor package 400 shown in FIG. 3 is only an example and is not a limitation to the present invention.

The semiconductor package 400 is mounted on the RDL structure 310 and is electrically connected to the RDL structure 310 through conductive components 410. The conductive components 410 are located in the openings 300 and protrude from the BSF 290. In some embodiments, the conductive components 410 are conductive bumps (such as micro bumps), conductive pillars, conductive paste structures, or another suitable conductive component. The conductive components 410 may include copper, solder, or another suitable conductive material. In some other embodiments, the conductive components 410 are surrounded by an underfill material.

In some embodiments, the semiconductor package 400 comprises a base 420, at least one semiconductor die (such as two vertically stacked semiconductor dies 430 and 440), bonding wires 450 and a molding compound 460. In some embodiments, the base 420 is a PCB and may be formed of PP or another suitable material. The base 420 is electrically connected to the RDL structure 310 through the conductive components 410.

The semiconductor die 430 is attached on the base 420 through an adhesive layer such as glue or another suitable adhesive material. The semiconductor die 43 is electrically connected to the base 420 through its pads 431 and the bonding wires 450. In some embodiments, the semiconductor die 430 is a memory die or another suitable semiconductor die. The semiconductor die 440 is attached on the semiconductor die 430 through an adhesive layer such as glue or another suitable adhesive material. The semiconductor die 440 is electrically connected to the base 430 through its pads 441 and the bonding wires 450. In some embodiments, the semiconductor die 440 is a memory die or another suitable semiconductor die. In some embodiments, the semiconductor dies 430 and 440 are DRAM dies.

The molding compound 460 covers the base 420 and surrounds the semiconductor dies 430 and 440. The bonding wires 450 are embedded in the molding compound 460. In some embodiments, the molding compound 460 is formed of a nonconductive material such as an epoxy, a resin, a moldable polymer, or another suitable molding material.

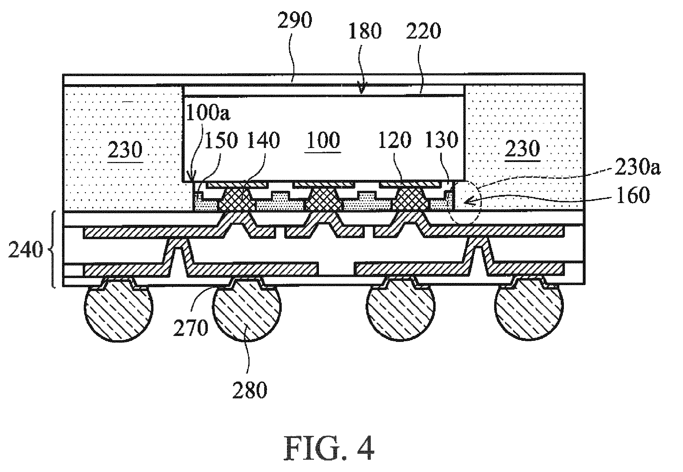

Many variations and/or modifications can be made to embodiments of the disclosure. FIG. 4 is a cross-sectional view of a semiconductor package structure, in accordance with some embodiments of the disclosure. Elements in FIG. 4 that are the same as those in FIGS. 1A-1G are labeled with the same reference numbers as in FIGS. 1A-1G and are not described again for brevity.

The structure of the semiconductor package structure shown in FIG. 4 is similar to that of the semiconductor package structure shown in FIG. 1G. The difference between them is that there are multiple conductive vias 210 enclosed by the molding compound 230 in FIG. 1G while there is no conductive vias in the molding compound 230 in FIG. 4. Furthermore, the BSF 290 in FIG. 1G includes openings 300 exposing the conductive vias 210 while there is no opening 300 in the BSF 290 in FIG. 4.

The semiconductor package structure and methods for forming the same in accordance with some embodiments of the disclosure provide various advantages. The semiconductor package structure includes a die. The die includes an insulating layer on a semiconductor body. An opening is formed in the insulating layer so that a sidewall of the insulating layer is retracted from a sidewall of the semiconductor body. The die is surrounded by a molding compound. As a result, the molding compound includes an extending portion filling the opening. Accordingly, a sidewall of the molding compound is non-coplanar with the sidewall of the semiconductor body so that the molding compound can act as a buffer layer for releasing stress.

The molding compound with the extending portion vertically overlapping the semiconductor body can block stress from pulling or tearing conductive traces, such as the conductive traces of the RDL structure on the molding compound. Therefore, defects or cracks in conductive traces as a result of concentrated stress can be prevented. Delamination at bi-material interfaces, such as an interface between the semiconductor body and the molding compound, can also be mitigated or eliminated. The quality and reliability of the semiconductor package structure is significantly improved.

Many variations and/or modifications can be made to embodiments of the disclosure. The semiconductor package structure and methods for forming the same in accordance with some embodiments of the disclosure can be used to form a three-dimensional (3D) package, a 2.5D package, a fan-out package, or another suitable package.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package structure, comprising:
a semiconductor body;
a conductive structure disposed below the semiconductor body;
an insulating layer surrounding the conductive structure;
a redistribution layer structure coupled to the conductive structure; and
a molding compound surrounding the semiconductor body, wherein a portion of the molding compound extends between the redistribution layer structure and the semiconductor body.

2. The semiconductor package structure as claimed in claim 1, wherein the semiconductor body has a surface facing the redistribution layer structure, and the portion of the molding compound is in direct contact with the surface of the semiconductor body.

3. The semiconductor package structure as claimed in claim 1 or claim 2, further comprising a dielectric layer between the semiconductor body and the insulating layer, wherein the dielectric layer surrounds a lower portion of the conductive structure and the insulating layer surrounds an upper portion of the conductive structure.

4. The semiconductor package structure as claimed in claim 3, wherein the portion of the molding compound is sandwiched between the redistribution layer structure and the dielectric layer.

5. The semiconductor package structure as claimed in one of the preceding claims, wherein the semiconductor body is wider than the insulating layer.

6. The semiconductor package structure as claimed in one of the preceding claims, wherein the portion of the molding compound vertically overlaps the semiconductor body; and/or
wherein the portion of the molding compound has a sidewall, and the sidewall is non-coplanar with a sidewall of the semiconductor body; and/or
wherein the portion of the molding compound surrounds the insulating layer.

7. A semiconductor package structure, comprising:
a semiconductor body;
a conductive pad disposed below a surface of the semiconductor body;
a redistribution layer structure disposed below the semiconductor body;
a conductive structure between the conductive pad and the redistribution layer structure, wherein the surface of the semiconductor body faces the redistribution layer structure;
an insulating layer between the surface of the semiconductor body and the redistribution layer structure, wherein a portion of the surface is exposed from the insulating layer; and
a molding compound surrounding the semiconductor body and covering the portion of the surface.

8. The semiconductor package structure as claimed in claim 7, wherein the molding compound extends from a sidewall of the semiconductor body to a sidewall of the insulating layer; and/or
wherein the molding compound covering the portion of the surface is sandwiched between the redistribution layer structure and the semiconductor body.

9. The semiconductor package structure as claimed in one of claims 7 and 8, wherein an extending length of the molding compound is in a range from 1 µm to 200 µm.

10. The semiconductor package structure as claimed in one of claims 7 to 9, wherein a sidewall of the molding compound adjoins the insulating layer and is non-coplanar with a sidewall of the semiconductor body.

11. The semiconductor package structure as claimed in one of claims 7 to 10, further comprising at least one of
a conductive via coupled to the redistribution layer structure, wherein a first portion of the molding compound between the conductive via and the insulating layer is wider than a second portion of the molding compound between the conductive via and the semiconductor body; and
an adhesive layer, wherein the semiconductor body is between the adhesive layer and the insulating layer and between the adhesive layer and the molding compound.

12. A method for forming a semiconductor package structure, comprising:
providing a die, wherein the die comprises:
a semiconductor body;
a conductive structure on a surface of the semiconductor body; and
an insulating layer surrounding the conductive structure, wherein a portion of the surface is exposed from the insulating layer;
forming a molding compound surrounding the semiconductor body and covering the portion of the surface; and
forming a redistribution layer structure on the molding compound and the insulating layer.

13. The method as claimed in claim 12, wherein the formation of the die comprises:
forming a first opening in the insulating layer to expose the portion of the surface; and
forming a second opening in the semiconductor body along the first opening.

14. The method as claimed in claim 12 or claim 13, wherein the first opening is wider than the second opening; and/or.
wherein the second opening is in communication with the first opening and penetrates the semiconductor body.

15. The method as claimed in one of claims 12 to14, further comprising performing a thinning process over the molding compound vertically overlapping the semiconductor body.
